# EUROPÄISCHE PATENTSCHRIFT

(11) **EP 3 078 033 B1**
(45) Veröffentlichungstag und Bekanntmachung des Hinweises auf die Patenterteilung: **18.10.2017**
(21) Anmeldenummer: 15709434.3
(22) Anmeldetag: 26.02.2015
(51) Int. Cl.: H01B 7/29, H02K 3/02, H02K 3/40, H02K 3/52, H01B 3/52, H02K 3/30, H05K 9/00

(54) **LEITFÄHIGES GLIMMSCHUTZPAPIER, INSBESONDERE FÜR DEN AUSSENGLIMMSCHUTZ**
CONDUCTING CORONA SHIELDING PAPER, IN PARTICULAR FOR OUTER CORONA SHIELDING
PAPIER ANTI-EFFLUVES CONDUCTEUR, DESTINÉ NOTAMMENT À LA PROTECTION ANTI-EFFLUVES EXTÉRIEURE

(30) Priorität: 28.02.2014 DE 102014203744
(43) Veröffentlichungstag der Anmeldung: 12.10.2016
(73) Patentinhaber: Siemens Aktiengesellschaft, 80333 München (DE)
(72) Erfinder: KLAUSSNER, Bernhard, 90408 Nürnberg (DE); LANG, Jiri, 90461 Nürnberg (DE); LANG, Steffen, 91352 Hallerndorf (DE); LITINSKY, Alexander, 40233 Düsseldorf (DE); SCHMIDT, Guido, 42799 Leichlingen (DE); SCHULZ-DROST, Christian, 90427 Nürnberg-Neunhof (DE); SCHÄFER, Klaus, 90455 Nürnberg (DE); STAUBACH, Christian, 45768 Marl (DE); EDER, Florian, 91052 Erlangen (DE)
(86) Internationale Anmeldenummer: PCT/EP2015/054070
(87) Internationale Veröffentlichungsnummer: WO 2015/128432

(56) Entgegenhaltungen:
- WO-A1-03/107512
- WO-A1-2012/152262
- DE-A1-102010 009 462
- DE-A1-102011 075 425
- US-A1- 2013 260 139

## Beschreibung

Die Erfindung betrifft ein leitfähiges Glimmschutzpapier zum Einsatz in einem Glimmschutzsystem für eine elektrische Maschine, beispielsweise eine Hochspannungsmaschine, wie einem Generator zur Erzeugung von elektrischer Energie, einem elektrischen Motor, aber auch andere elektrische Betriebsmittel mit einer höheren Bemessungsspannung wie Trafos, Durchführungen, Kabel etc.

Es werden immer leistungsstärkere Maschinen, wie beispielsweise Generatoren, entwickelt, da die fortschreitende Technik immer höhere Leistungsdichten verlangt. Ein leistungsstarker Generator, wie beispielsweise ein Turbogenerator, weist insbesondere einen Ständer (Stator) mit einem Ständerblechpaket und einer Mehrzahl an Generatornuten, in denen sich die Generatorwicklung befindet.

Die Hauptisolierung dieser Wicklung gegen das Blechpaket ist ein elektrisch hoch beanspruchtes System. Im Betrieb entstehen hohe Spannungen, welche in dem Isoliervolumen zwischen dem auf Hochspannung befindlichen Leiterstab und dem auf Erdpotential liegendem Blechpaket abgebaut werden müssen. An den Kanten der Bleche im Blechpaket entstehen dabei Feldüberhöhungen, die ihrerseits Teilentladungen hervorrufen. Diese Teilentladungen führen bei Auftreffen auf das Isolationssystem lokal zu sehr starken Erhitzungen. Dabei werden die organischen Materialien des Isoliersystems inklusive die des Außenglimmschutzsystems sukzessive in niedermolekulare, volatile Produkte, beispielsweise in CO₂, zersetzt.

Ein wichtiger Bestandteil des Isolationssystems ist der so genannte Außenglimmschutz (AGS). Er wird bei größeren Generatoren und Elektromotoren direkt auf die Oberfläche der Wicklungsisolation appliziert. Der AGS besteht aktuell aus Ruß und Graphit haltigen Glimmschutzpapieren.

Da systembedingt vor allem die Grenzfläche zwischen AGS und Hauptisolation nicht vollständig porenfrei hergestellt werden kann, kommt es bei entsprechend hohen elektrischen Feldstärken im Isolationssystem zu einer entsprechend hohen elektrischen Teilentladungsaktivität, die den Außenglimmschutz im Betrieb im Laufe der Zeit komplett verbrennt und somit zu einer vorzeitigen Alterung der Isolierung und im schlimmsten Fall zu einem Erdschluss der elektrischen Maschine führt. Das entspricht einem irreparablen Komplettausfall der Maschine.

Der Außenglimmschutz muss einen gewissen Quadratwiderstand aufweisen, welcher in einem bestimmten Bereich liegt. Ist er zu gering, können die Blechpakete elektrisch kurzgeschlossen werden, was zu hohen induzierten Kreisströmen führen kann, welche sich über die Enden des Blechpakets und dem Außenglimmschutz erschließen und zu stromstarken Lichtbögen führen. Bei zu hohem Widerstand kann es wiederum zu Hochspannungsfunkenerosion kommen. Idealerweise wäre der Widerstand im Außenglimmschutzsystem einstellbar, so dass eine Anisotropie herstellbar wäre, die erhöhte Leitfähigkeit in radialer Richtung, also vom stromführenden Leiter zum Blechpaket hin, und ein erhöhter Widerstand, also geringe Leitfähigkeit, in Stabrichtung zeigt.

Aufgabe der vorliegenden Erfindung ist es daher, die Nachteile des Standes der Technik zu überwinden, ein teilentladungsresistentes und elektrisch leitfähiges Glimmschutzpapier zur Verfügung zu stellen.

Diese Aufgabe wird durch den Gegenstand der vorliegenden Erfindung, wie er in der Beschreibung und den Ansprüchen offenbart wird, gelöst.

Dementsprechend ist Gegenstand der vorliegenden Erfindung ein Glimmschutzpapier, planare und elektrisch leitfähig beschichtete Partikel umfassend, wobei zur gezielten Einstellung der elektrischen Leitfähigkeit den planaren Partikeln noch globulare Partikel zugemischt werden.

Nach einer vorteilhaften Ausführungsform der Erfindung werden dem Glimmschutzpapier noch Verstärkungsfasern zugegeben.

Nach einer weiteren vorteilhaften Ausführungsform der Erfindung wird bei der Herstellung des Glimmschutzpapiers ein Gewebe vorgelegt, um das herum und/oder in dessen Maschen sich das Glimmschutzpapier bildet. Das Gewebe kann, je nach Größe der Maschen Glimmschutzpapier mit oder auch ohne Verstärkungsfasern enthalten. In jedem Fall ist die zur Stabilisation des Papiers erforderliche Menge an Verstärkungsfasern bei Vorliegen eines Gewebes entsprechend reduziert.

Bei der Herstellung von Glimmschutzpapier werden die plättchenförmigen und leitfähig beschichteten Partikel schichtartig angeordnet, so dass sich die Partikel weitgehend parallel zueinander anordnen, wobei unmittelbar übereinanderliegende Partikel sich unter Ausbildung von Kontaktoberflächen überlappen. Zwischen den Kontaktoberflächen bilden sich als Folge von van-der-Waals Kräften und Wasserstoffbrückenbindungen Wechselwirkungen aus, welche dem Glimmschutzpapier ein hohe mechanische Belastbarkeit und damit eine stabile Form geben. Folgende bekannte Verfahren sind zur Herstellung des Glimmschutzpapiers beispielsweise einsetzbar: Cylinder Mould-Verfahren und Fourdrinier-Verfahren.

Zur Verbesserung der mechanischen Eigenschaften (e.g. Festigkeit, Verarbeitbarkeit, etc.) werden dem Glimmschutzpapier beispielsweise noch Fasern auf organischer oder anorganischer Basis hinzugefügt. Organische Fasern können beispielsweise durch meta-/para-Aramid oder Polyester (PET) dargestellt werden. Anorganische Fasern können beispielsweise Glasfasern sein.

Bei einer Ausführungsform liegen die Dimensionen der Fasern vom Durchmesser her im Nanometerbereich, beispielsweise also bei 1 bis 500nm und/oder µm-Bereich als 0,5 bis 10 µm. Die Länge der Fasern ist immer um Größenordnungen höher, beispielsweise im mm-Bereich, bis hin zum, bevorzugt einstelligen, cm-Bereich.

Nach einer Ausführungsform der Erfindung wird das Glimmschutzpapier durch ein Gewebe und/oder Fasern verstärkt, wobei dann beispielsweise auch ein Glimmschutzband resultiert. Das Verfahren zur Herstellung des Glimmschutzbandes umfasst beispielsweise folgende Prozessschritte: Mischen einer Dispersion, die teilentladungsresistente und elektrisch leitfähige, planare Partikeln umfasst mit einem Trägerfluid; Erzeugen eines Bodensatzes durch Sedimentation der Dispersion, wodurch die planaren Partikel im Wesentlichen schichtartig planparallel in dem Bodensatz angeordnet werden; Einbringen eines Gewebes in den Bodensatz und Entfernen des Trägerfluids aus dem Bodensatz.

Nach einer vorteilhaften Ausgestaltung der Erfindung liegt das Gewebe netzartig vor, so dass in der Netzstruktur Maschen vorhanden sind, die mit Glimmschutzpapier befüllbar sind. Beispielsweise bildet sich - auch - innerhalb der Maschen ein Bereich mit Glimmschutzpapier aus.

Nach einer vorteilhaften Ausführungsform der Erfindung umfasst der Partikelverbund plättchen- und kugelförmige Partikel, wobei die plättchenförmigen Partikel insbesondere bevorzugt mit einem Aspektverhältnis von mindestens 10, also mit einem Verhältnis von Plättchenlänge zu Plättchendicke von mindestens 10 vorliegen.

Bevorzugt umfassen die Partikel einen teilentladungsresistenten Kern und einer teilentladungsresistenten Beschichtung, die leitfähig ist.

Der Begriff "teilentladungsresistent" bezieht sich dabei auf Materialien, die - beispielsweise - bei Teilentladungen an Luft gegen Oxidation resistent sind oder die ansonsten bei Teilentladungen stabil bleiben, wie Keramiken und/oder Gläser.

Nach einer vorteilhaften Ausführungsform ist der teilentladungsresistente Kern aus einem keramischen oder glasartigen Material, was vorzugsweise eine geringe Dichte aufweist und vorzugsweise Glimmer, Quarzmehl, Aluminiumoxid oder Glasplättchen ist.

Bei einer planaren Struktur der Partikel wird eine verbesserte Kontaktierung der leitfähigen Partikel untereinander erreicht. Bevorzugtermaßen wird das, die Partikel beschichtende Material ein Metalloxid sein und aus der Gruppe Zinnoxid, Zinkoxid, Zinkstannat, Titandioxid, Bleioxid oder nichtoxidisch Siliziumcarbid umfassend, ausgewählt. Das Dotierungselement wird bevorzugt aus der Gruppe: Antimon, Indium, Cadmium ausgewählt.

Bei der Herstellung der Isolation wird das Glimmschutzpapier um den zu isolierenden Leiter gewickelt und mit einem Harz imprägniert. Anschließend wird der Verbund aus dem Harz und dem Glimmschutzpapier ausgehärtet. Zusätzlich oder alternativ kann das Glimmschutzpapier auf ein Trägergewebe aus Glas, Kunststoff wie Polyester und/oder PET aufgebracht sein, wobei ein Gewebe als Träger dem Glimmschutzpapier zusätzliche Stabilität verleiht. Ein Kleber oder eine polymere Matrix verbindet gegebenenfalls das Gewebe und das Glimmschutzpapier zu einem Glimmerband.

Ein besonderer Aspekt der Erfindung ist die Mischung von sphärischen und planaren Partikeln. Aus der DE 102010009462.5 ist bekannt, dass zur Herstellung des Außenglimmschutzes planare plättchenförmige Partikel eingesetzt werden, die durch ihre Ausrichtung während des Herstellungsprozesses und deren leitfähige Beschichtung Leitfähigkeitspfade schaffen, entlang derer die Leitfähigkeit hoch und der Widerstand gering ist. Nachteilig daran ist, dass die Leitfähigkeit senkrecht dazu, also in radialer Richtung, wo die plättchenförmigen Partikel nur eine sehr geringe Ausdehnung haben, ziemlich gering ist. Wie oben erwähnt, wäre jedoch die Leitfähigkeit gerade in dieser radialen Richtung erwünscht.

Bevorzugt werden die Partikel in Mikrogröße eingesetzt, beispielsweise haben die Plättchen eine Breite und Länge im Mikrometerbereich, also beispielsweise im Bereich von 1 bis 300 µm, insbesondere von 1 bis 100 µm und insbesondere bevorzugt von 1 bis 40 µm, wohingegen ihr Durchmesser in Dickenrichtung im Nanometerbereich also zwischen 50 und 1000 nm liegt, insbesondere im Bereich von 100nm bis 1000 nm. Die sphärischen Partikel haben beispielsweise einen Durchmesser im Bereich von 0,5 bis 50µm, insbesondere von 1 bis 10µm.

Die globularen Partikel werden beispielsweise in einer Menge bis zu einem Drittel der Gesamtmenge an Partikel zugeführt.

Die planare Geometrie, sowie die Ausrichtung des Füllstoffes im Glimmschutz senkrecht zur Feldbelastung verlängern deutlich den Erosionsweg durch den Glimmschutz im Vergleich zu einem Glimmschutz, der nur aus globularen Füllstoffen besteht. Deshalb ist die Menge der den plättchenförmigen Partikeln zugesetzten sphärischen Partikel in dem Spannungsfeld auszuwählen zwischen der Erhöhung des Erosionsweges durch möglichst vollständige plättchenförmige Partikel und Einstellung einer anisotropen Leitfähigkeit durch globulare Partikel.

Nach einer vorteilhaften Ausführungsform des Verfahrens wird beim Mischen der Dispersion aus Partikeln mit dem Trägerfluid noch ein Funktionalisierungsmittel zugesetzt, das in dem Trägerfluid verteilt ist und in der Dispersion einen Massenanteil hat, der bezogen auf den Massenanteil der Partikel einem vorherbestimmten Massenverhältnis entspricht.

Vor dem Mischen der Dispersion werden die Partikel bevorzugt mit einer im Wesentlichen monomolekularen Dünnschicht auf der Oberfläche der Partikel ausgebildet, wobei die Dünnschicht aus einem weiteren Funktionalisierungsmittel hergestellt wird. Die chemische Reaktion zum Kuppeln der Partikel erfolgt zwischen der Dünnschicht und dem Funktionalisierungsmittel.

Zu der Dispersion aus den Partikeln mit der im Wesentlichen monomolekularen Dünnschicht und dem Trägerfluid werden alternativ bevorzugt Partikel gegeben, die eine im Wesentlichen monomolekulare Dünnschicht aufweisen, welche von der Dünnschicht der ursprünglich in der Dispersion vorhandenen Partikeln verschieden ist. Die chemische Reaktion zum Kuppeln der Partikel erfolgt zwischen zwei oder mehr verschiedenen Dünnschichten.

Nach einer weiteren vorteilhaften Ausführungsform des Verfahrens wird nach dem Entfernen des Trägerfluids aus dem Bodensatz noch ein Prozessschritt angefügt, in dem Energie in den Bodensatz zum Überwinden der Aktivierungsenergie derjenigen chemischen Reaktion des Funktionalisierungsmittels mit den Partikeln, die unter Kuppeln der Partikel via das Funktionalisierungsmittel aus dem Bodensatz den Partikelverbund ausbildet, eingebracht, wobei das Massenverhältnis derart vorherbestimmt wird, dass der Partikelverbund eine poröse Struktur hat. Das derartig ausgebildete Kuppeln der Partikel verstärkt die Wechselwirkungen der Partikel untereinander, so dass vorteilhaft der Partikelverbund eine ausreichende Festigkeit zur Papierherstellung hat.

Das Funktionalisierungsmittel wird bevorzugt derart gewählt, dass es ein Kunststoff, insbesondere ein Thermoplast, ist. Der Kunststoff wird bevorzugt derart gewählt, dass er ein Polyolefinalkohol, insbesondere Polyethylenglycol oder ein nicht vollständig hydrolysierter Polyvinylalkohol mit einer Molekülmasse zwischen 1000 und 4000, oder ein Polyalkylsiloxan, insbesondere Methoxy-terminiertes Polydimethylsiloxan, oder ein Silikonpolyester ist. Ferner wird das Funktionalisierungsmittel bevorzugt derart gewählt, dass es ein Alkoxysilan ist und eine im Wesentlichen monomolekulare Dünnschicht auf der Partikeloberfläche ausbildet. Das Alkoxysilan wird bevorzugt derart gewählt, dass es Epoxidgruppen, insbesondere 3-Glycidoxypropyltrimethoxysilan, oder Aminogruppen, insbesondere 3-Aminopropyltriethoxysilan, aufweist. Ferner wird das Funktionalisierungsmittel bevorzugt derart gewählt, dass es Partikel aufweist, insbesondere Nanopartikel aus Siliziumdioxid, die oberflächliche Epoxidfunktionalitäten tragen.

Das erfindungsgemäße Verfahren wird bevorzugt derart durchgeführt, dass die Energie zum Überwinden der Aktivierungsenergie in Form von Wärme und/oder Strahlung dem Bodensatz mit dem Gewebe zugeführt wird. Ferner wird das erfindungsgemäße Verfahren bevorzugt derart durchgeführt, dass das Entfernen des Trägerfluids durch Filtration und anschließender Zufuhr von Wärme erfolgt. Das Entfernen des Lösungsmittels durch Zufuhr von Wärme und die Zufuhr von Wärme zum Überwinden der Aktivierungsenergie kann vorteilhaft in einem Verfahrensschritt erfolgen. Dabei wird das Trägerfluid bevorzugt derart gewählt, dass es Wasser ist.

Nach einer vorteilhaften Ausführungsform erfolgt das Entfernen des Bodensatzes nach Zugabe des Gewebes durch Filtration, so dass die plättchenförmigen Partikel durch das Gewebe durchgesaugt werden.

Durch das Einbringen des Gewebes wird eine mechanische Verzahnung des Bodensatzes mit dem Gewebe erzeugt. Dies vereinfacht nicht nur den Fertigungsprozess, sondern schafft auch eine bessere Ankopplung der Partikel an das Gewebe.

Das Trägerfluid ist bevorzugt ein Lösungsmittel, in dem das Funktionalisierungsmittel lösbar ist, wobei das Funktionalisierungsmittel in dem Lösungsmittel gelöst ist. Das Funktionalisierungsmittel wird bevorzugt derart gewählt, dass es eine im Wesentlichen monomolekulare Dünnschicht auf der Oberfläche der Partikel ausbildet. Die chemische Reaktion zum Kuppeln der Partikel erfolgt zwischen den Dünnschichten.

Das Glimmschutzpapier kann trägerlos, also ohne Verstärkungs-Gewebe aufgetragen werden. In dem Fall bietet die vorliegende Erfindung den Vorteil, dass die trägerlose Aufmachung des elektrisch leitfähigen Papiers auf Basis der beschichteten Zinnoxid-Partikel eine Grenzflächen-freie Anbindung des Papiers an die Hauptisolierung ermöglicht.

Die Zugabe von Fasern zur Verstärkung kann beliebig eingestellt werden, beispielsweise können die Fasern in einer Menge von 5 bis 50 Gew% zugesetzt werden, dadurch ergeben sich die Variationsmöglichkeiten, dass bei einem hohen Anteil von organischen Fasern die Herstellung eines mechanisch stabilen Papiers zur Anwendung als leitfähige Nutauskleidung eines Niederspannungs-Isoliersystems mit resultierender Erhöhung der TE-Einsetzspannungen (Feldüberhöhungen an den Kanten der Bleche werden reduziert) ermöglicht wird.

Umgekehrt führt ein niedriger Anteil von organischen Fasern zur Herstellung eines trägerlosen Glimmschutzbandes, insbesondere Außenglimmschutzbandes für Hochspannungs-Isoliersysteme.

Alternativ zur diskreten Anwendung kann das trägerlose, leitfähige Papier auf Basis der Zinnoxid-Partikel als einseitige halb-leitfähige Schicht von Verbundwerkstoffen genutzt werden.

Durch die Beimischung globularer Partikel können verschiedene Leitfähigkeiten eingestellt werden.

Bei der Ausführungsform der Erfindung mit Gewebe kann zur Herstellung des Glimmschutzbandes ein Band in einem Vakuum-Druck-Verfahren imprägniert werden. Dadurch entsteht eine sehr gute Anbindung von Glimmerbandwicklung und Außenglimmschutzwicklung.

Bei der Herstellung werden die planaren Partikel ausgerichtet, so dass eine Erosionswegsverlängerung, die die Lebensdauer des gesamten Isolationssystems verlängert, resultiert.

Die Erfindung betrifft ein Glimmschutzpapier zum Einsatz in einem Glimmschutzsystem für eine elektrische Maschine, beispielsweise eine Hochspannungsmaschine. Das Glimmschutzpapier wird im einfachsten Fall durch Verdichten von planaren teilentladungsresitiven und leitfähigen Partikeln hergestellt, kann aber sowohl Verstärkungsfasern, als auch ein Gewebe umfassen.

## Patentansprüche

1. Glimmschutzpapier, planare und elektrisch leitfähig beschichtete Partikel umfassend, wobei zur gezielten Einstellung einer anisotropen elektrischen Leitfähigkeit den planaren Partikeln globulare Partikel zugemischt werden.

2. Glimmschutzpapier nach Anspruch 1, wobei die Partikel einen teilentladungsresistenten Kern und eine teilentladungsresistenten Beschichtung haben, die leitfähig ist.

3. Glimmschutzpapier nach einem der vorstehenden Ansprüche, wobei in dem Glimmschutzpapier noch Verstärkungsfasern enthalten sind.

4. Glimmschutzpapier nach Anspruch 3, wobei die Verstärkungsfasern eine organische oder anorganische Basis haben.

5. Glimmschutzpapier nach einem der vorstehenden Ansprüche, wobei in dem Glimmschutzpapier noch ein Gewebe zur Stabilisierung und als Träger enthalten ist.

6. Glimmschutzpapier nach einem der vorstehenden Ansprüche, wobei die Partikel mit einem Metalloxid beschichtet sind.

7. Glimmschutzpapier nach einem der vorstehenden Ansprüche, wobei die Partikel mit einem dotierten Metalloxid beschichtet sind.

## Claims

1. Corona shielding paper, comprising planar and electrically conductively coated particles, with globular particles also admixed with the planar particles for selective setting of an anisotropic electrical conductivity.

2. Corona shielding paper according to Claim 1, the particles having a core that is resistant to partial discharges and a coating that is resistant to partial discharges and is conductive.

3. Corona shielding paper according to one of the preceding claims, reinforcing fibers also being contained in the corona shielding paper.

4. Corona shielding paper according to Claim 3, the reinforcing fibers having an organic or inorganic basis.

5. Corona shielding paper according to one of the preceding claims, a woven fabric also being contained in the corona shielding paper for stabilization and as a carrier.

6. Corona shielding paper according to one of the preceding claims, the particles being coated with a metal oxide.

7. Corona shielding paper according to one of the preceding claims, the particles being coated with a doped metal oxide.

## Revendications

1. Papier anti-effluves, comprenant des particules planaires et revêtues de manière électriquement conductrice, dans lequel en vue de l'ajustement ciblé d'une conductivité électrique anisotrope des particules globulaires sont mélangées aux particules planaires.

2. Papier anti-effluves selon la revendication 1, dans lequel les particules ont un coeur résistant à un déchargement partiel et un revêtement qui est conducteur et résistant à un déchargement partiel.

3. Papier anti-effluves selon l'une des revendications précédentes, dans lequel dans le papier anti-effluves sont en outre contenues des fibres de renfort.

4. Papier anti-effluves selon la revendication 3, dans lequel les fibres de renfort ont une base organique ou inorganique.

5. Papier anti-effluves selon l'une des revendications précédentes, dans lequel dans le papier anti-effluves est en outre contenu un tissu destiné à la stabilisation et servant de support.

6. Papier anti-effluves selon l'une des revendications précédentes, dans lequel les particules sont revêtues d'un oxyde de métal.

7. Papier anti-effluves selon l'une des revendications précédentes, dans lequel les particules sont revêtues d'un oxyde de métal dopé.
